# EUROPEAN PATENT SPECIFICATION

(11) **EP 2 148 375 B1**
(45) Date of publication and mention of the grant of the patent: **06.01.2016**
(21) Application number: 07743322.5
(22) Date of filing: 14.05.2007
(51) Int. Cl.: H01L 31/048

(54) **SOLAR CELL MODULE**
SOLARZELLENMODUL
MODULE DE CELLULE SOLAIRE

(43) Date of publication of application: 27.01.2010
(73) Proprietor: Mitsubishi Electric Corporation, Chiyoda-ku Tokyo 100-8310 (JP)
(72) Inventor: ITO, Naoki, Tokyo 100-8310 (JP); SUGANUMA, Yoshiyuki, Tokyo 100-8310 (JP); MIYAMOTO, Shinsuke, Tokyo 100-8310 (JP); MARUBAYASHI, Michiya, Tokyo 100-8310 (JP); SUZUKI, Issei, Tokyo 100-8310 (JP)
(74) Representative: Pfenning, Meinig & Partner GbR
(86) International application number: PCT/JP2007/059887
(87) International publication number: WO 2008/139611

(56) References cited:
- JP-A- 08 228 017
- JP-A- 10 012 911
- JP-A- 10 245 935
- JP-A- 2001 111 089
- JP-A- 2005 079 170
- JP-A- 2006 228 876
- JP-A- 2007 081 034

## Description

### TECHNICAL FIELD

The present invention relates to a solar cell module formed by arranging a plurality of solar battery cells in an array, and, more particularly to a solar cell module with a shape having an oblique side.

### BACKGROUND ART

Solar cell modules are often installed on an entire roof of a house. In a typical solar cell module, a plurality of solar battery cells having a substantially square shape or a substantially rectangular shape are arranged vertically and horizontally to match a module installation surface on the roof. Thus, on a gabled roof of which the module installation surface is rectangular, it is easy to arrange the solar battery cells with no gap therebetween. However, on a hip roof of which the module installation surface is trapezoidal or triangular, solar battery cells are arranged stepwise at an oblique portion of the module installation surface. As a result, a sawtooth-shaped gap (a blank region), like triangles are lined up, is formed.

While such a solar cell module is normally manufactured in a laminated structure, a weather resistant film arranged on the bottom surface of the module to improve its weather resistant property is generally rendered white for the purpose of reflecting light taken from a light-receiving surface side to a side of the solar battery cell. On the other hand, the top surface of the solar battery cell is often rendered dark, such as black, to match the color of roof tiles or the like. Therefore, the blank region where no solar battery cell is arranged results in a sawtooth shape with a color tone different from other parts, and it is not favorable in terms of designing. To solve this problem, there has conventionally been proposed that triangular solar battery cells are arranged in the sawtooth-shaped blank region, or a light-receiving surface side of a weather resistant film is colored in a sawtooth shape (for example, see Patent Document 1).

Patent Document 1: Japanese Patent No. 3410315 Document JP 8 228 017 discloses a solar cell module according to the preamble of claim 1

### DISCLOSURE OF INVENTION

### PROBLEM TO BE SOLVED BY THE INVENTION

However, as for the method of arranging the triangular solar battery cells, there is a problem that it is not easy to manufacture triangular solar battery cells, and electrical connections with adjoining square solar battery cells become complicated. Further, as for the method of coloring dark the light-receiving surface side of the weather resistant film, it is difficult to color the weather resistant film at the sawtooth-shaped portion in a manner to exactly match the shape, thereby increasing the cost. Thus, there is a need for improvements.

The present invention has been achieved in view of the above problems, and an object of the invention is to obtain a solar cell module with improved productivity and better design without causing cost increase.

### MEANS FOR SOLVING PROBLEM

To solve the above problems and to achieve the above objects, a solar cell module according to claim 1 is provided.

### EFFECT OF THE INVENTION

According to the present invention, a solar battery cell and a thin plate are arranged on the same cell arrangement layer, and thus good designing is enabled without causing any sense of discomfort. Further, it suffices that the thin plate is arranged on a cell arrangement layer at a step same as a step in which solar battery cells are arranged on a cell arrangement layer. Therefore, arrangement of the thin plate can be easily performed, the productivity is improved, and no cost increased is incurred.

### BRIEF DESCRIPTION OF DRAWINGS

[Fig. 1] Fig. 1 is a front view of a solar cell module which is not part of the present invention.
[Fig. 2] Fig. 2 is a cross-sectional arrow view taken along a line A-A in Fig. 1
[Fig. 3] Fig. 3 is an enlarged view of an obtuse-angled corner between an oblique side and an adjacent side for explaining a gap between a thin plate and a frame.
[Fig. 4] Fig. 4 is an enlarged view of an obtuse-angled corner between an oblique side and an adjacent side for explaining a gap between a thin plate and a solar battery cell.
[Fig. 5] Fig. 5 is a front view for explaining arrangement output lines. of connecting lines and output lines.
[Fig. 6] Fig. 6 is an enlarged view of an obtuse-angled corner between an oblique side and an adjacent side for explaining a gap between a solar battery cell and an output line.
[Fig. 7] Fig. 7 which is not part of the present invention is a cross-sectional view for explaining hiding of connecting lines and output lines by the thin plate.
[Fig. 8] Fig. 8 is a cross-sectional view for explaining an arrangement of the connecting lines and the output lines according to the present invention.
[Fig. 9] Fig. 9 is an enlarged view of an obtuse-angled corner between an oblique side and an adjacent side for explaining a positioning protrusion provided on a thin plate.

### EXPLANATIONS OF LETTERS OR NUMERALS

10 solar battery cell
20 thin plate
21a positioning protrusion
21 to 25 frame
27a to 27c connecting line (wire extending to solar battery cell)
28a, 28b output line (wire extending to solar battery cell)
31 transparent substrate (glass)
32, 34 sealing resin
35 weather resistant film (bottom surface film)
C cell arrangement layer
D blank region

### BEST MODE FOR CARRYING OUT THE INVENTION

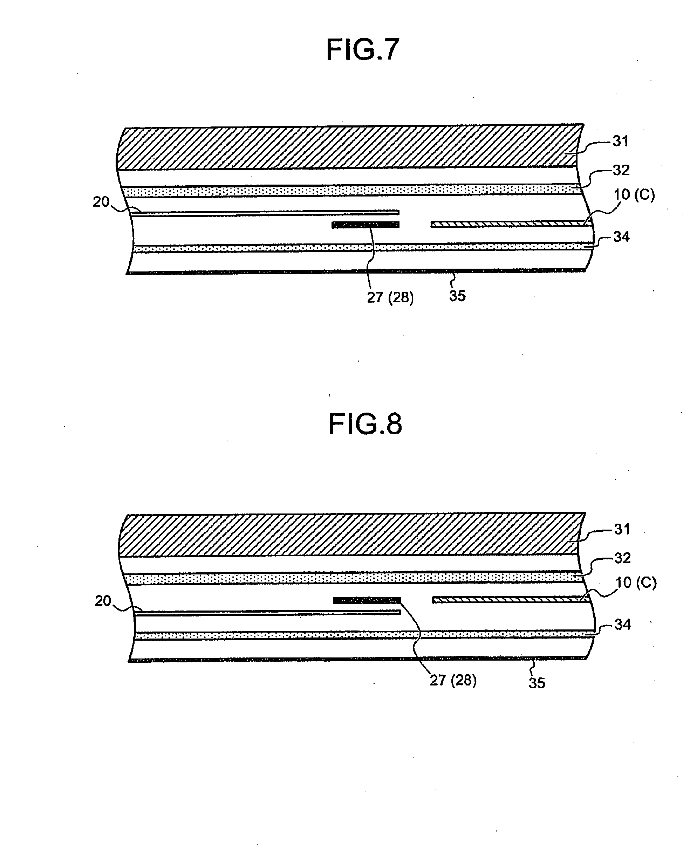

An exemplary embodiment of a solar cell module according to the present invention will be explained below with reference to Fig. 8. The present invention is not limited to this embodiment.

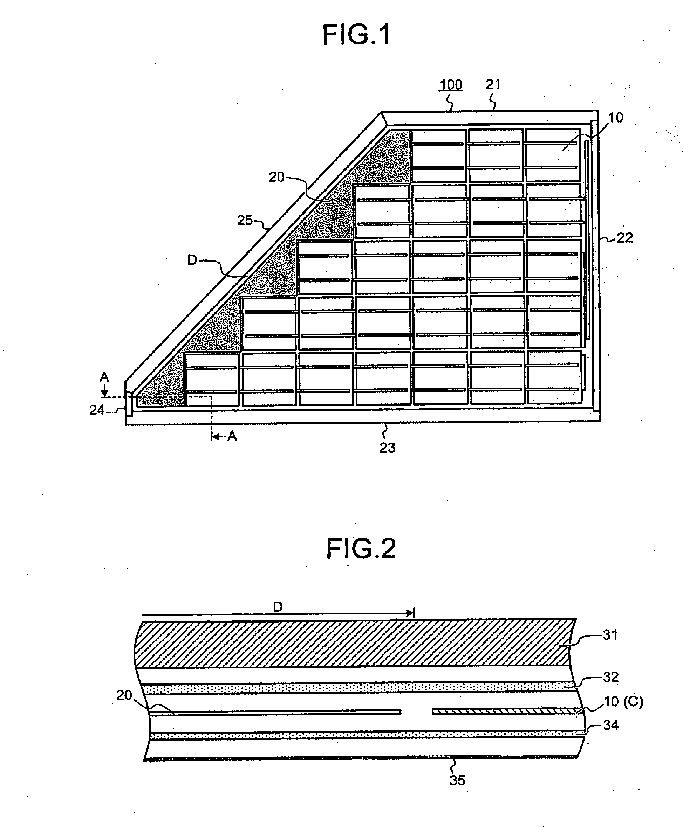

Fig 1 is a front view of a solar cell module which is not part of the present invention. A solar cell module 100 shown as an example in Fig. 1 has a substantially plate-like shape, and in a substantially trapezoidal shape of which one side is oblique. Solar battery cells 10 arranged on a plane surface are arranged to correspond to the oblique side while the number thereof is gradually decreased toward an upper stage from a lower stage in Fig. 1. That is, at a first stage of the lowest stage, seven solar battery cells 10 are arranged, at a second stage, six solar battery cells 10 are arranged, at a third stage, five solar battery cells 10 are arranged, at a fourth stage, four solar battery cells 10 are arranged, and at a fifth stage, three solar battery cells 10 are arranged. Further, each of the solar battery cells 10 has a substantially square and plate-like shape, and thus the edge on the oblique side of a solar battery cell group is rendered stepwise. Accordingly, between the solar battery cell group and the oblique side, there is formed a sawtooth-shaped blank region D (a region where the solar battery cells 10 are not provided) that is of shape which is obtained by connecting a plurality of triangles so that respective tops are overlapped with one another. A thin plate 20 having a shape substantially same as that of the blank region D and having a color tone same as that of the solar battery cells 10 is arranged to cover the entire region of the blank region D. An outer peripheral edge of the solar cell module 100 includes frames 22, 23, 24, and 25 that cover the entire circumference of the solar cell module 100.

Fig. 2 is a cross-sectional arrow view taken along a line A-A in Fig. 1. In Fig. 2, to facilitate understanding of various members in each of laminated layers, the thickness of each layer is shown larger and gaps are interposed between the respective layers. However, in practice, each layer is very thinly formed and closely adhered. The solar cell module 100 is structured by laminating a plurality of layers including a cell arrangement layer C, on which the plurality of solar battery cells 10 is arranged. The thin plate 20 is arranged on the cell arrangement layer C of the blank region D. That is, the solar battery cells 10 and the thin plate 20 are arranged on the same cell arrangement layer C.

Explanation is given below in more detail. In Fig. 2, on an upper side, that is a light-receiving surface side in Fig. 2, there is formed a layer made of a transparent substrate (glass) 31. The transparent substrate 31 is transparent and formed as a single layer to cover the entire top surface of the solar cell module 100. A layer of a first sealing resin 32 is formed on the bottom-surface side of the transparent substrate 31. On a deeper bottom-surface side of the first sealing resin 32, there is formed the cell arrangement layer C. The solar battery cells 10 and the thin plate 20 are arranged on the cell arrangement layer C. On a deeper bottom-surface side of the cell arrangement layer C, there is formed a layer by a second sealing resin 34. That is, the cell arrangement layer C is sandwiched by two sealing resin layers. The sealing resin is semi-transparent originally and becomes transparent when being cured.

On a deeper bottom-surface side of the second sealing resin 34, there is formed a weather resistant film (bottom surface film) 35. The weather resistant film 35 forms the bottom surface of the completed solar cell module 100. The weather resistant film 35 is provided to improve the weather resistant property of the solar cell module 100. The weather resistant film 35 is rendered bright in color, and more specifically white. The top surface on the light-receiving surface side of the solar battery cells 10 is dark in color, and more specifically black. The thin plate 20 is arranged on the cell arrangement layer C at a step same as a step in which the solar battery cells 10 in arranged on the cell arrangement layer C.

As described above, the thin plate 20 is arranged on the same cell arrangement layer C as that of the solar battery cells 10, and the thickness of the thin plate 20 is the same as, or smaller than, that of the solar battery cell 10. The thin plate 20 is arranged such that it is sandwiched by the two sealing resin layers 32 and 34 between layers made of the transparent substrate 31 and the weather resistant film 35. The thin plate 20 is made of an electric insulating material such as polyethylene terephthalate (PET). The polyethylene terephthalate has a lower affinity with the sealing resin. Therefore, for the purposes of improving a bonding force between the thin plate 20, and the sealing resin layers 32 and 34, surface processing is preferably performed. Examples of the surface processing include scratching the top surface or pressing against the top surface by an irregular surface to physically form irregularities, or coating both of the thin plate 20 and the sealing resin layers 32 and 34 with a coating material having affinity. By this processing, the adhesion between the thin plate 20 and the sealing resin layers 32 and 34 is improved whereby generation of air bubbles or the like can be suppressed.

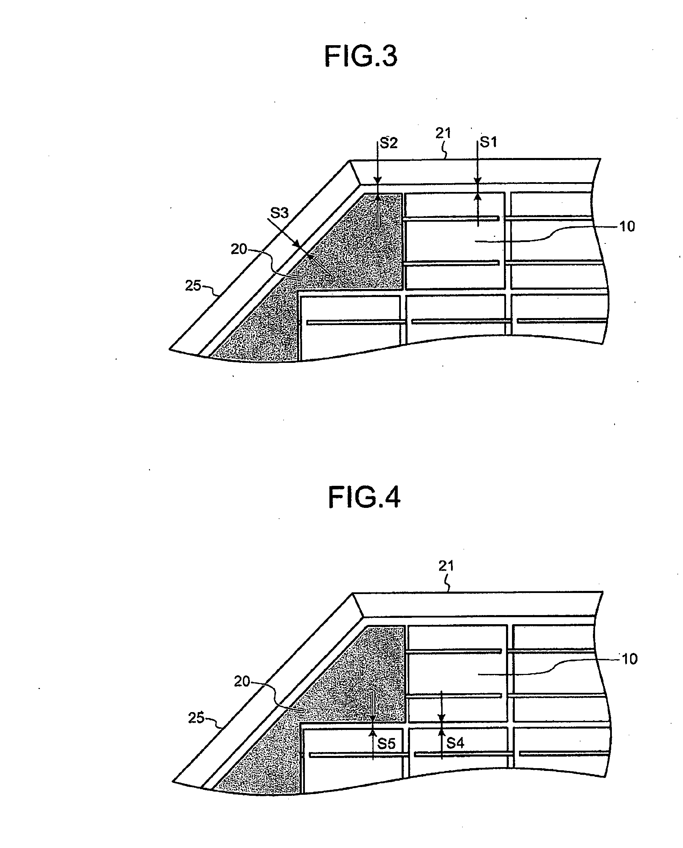

Fig. 3 is an enlarged view of an obtuse-angled corner between an oblique side and an adjacent side for explaining a gap between a thin plate and a frame. A gap by a predetermined creeping distance is secured between the solar battery cells 10 and the frame. The gap functions to prevent short-circuit that is caused due to contact between an internal circuit, such as the solar battery cell 10, and the frame via water as a result of unforeseen generation of damage on the weather resistant film 35. In the present embodiment, a size of a gap S2 between the thin plate 20 and a frame 21, and a size of a gap S3 formed between the thin plate 20 and the frame 25 are rendered substantially the same as a size of a gap S1 between the solar battery cell 10 and the frame 21. In other positions, a size of a gap between the thin plate 20 and the frame is rendered substantially the same as the size of the gap between the solar battery cell 10 and the frame.

Fig. 4 is an enlarged view of the obtuse-angled corner between the oblique side and the adjacent side for explaining a gap between the thin plate and a solar battery cell. A size of a gap S5 between the thin plate 20 and the solar battery cell 10 is rendered substantially the same as a size S4 of a gap between the solar battery cells 10. In positions other than those shown in Fig. 4, the size of the gap S5 between the thin plate 20 and the solar battery cell 10 is rendered substantially the same as the size S4 of the gap between the solar battery cells 10. Thus, by having a gap on a periphery of the thin plate 20 same as a gap on a periphery of the solar battery cells 10, the designing property is improved.

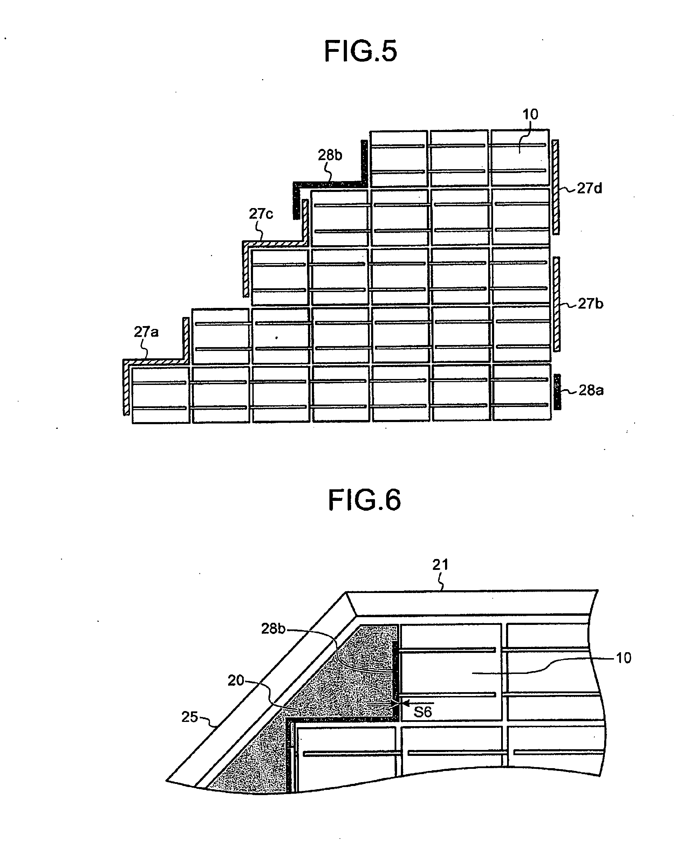

Fig. 5 is a front view of a state that connecting lines and lead lines are arranged. In Fig. 5, the solar battery cells 10 arranged at respective stages are serially connected, and further, the solar battery cells at the respective stages are serially connected by connecting lines 27a to 27c. Therefore, all of the solar battery cells 10 are serially connected. That is, first, seven solar battery cells 10 at a first stage in Fig. 5 are serially connected and the solar battery cells 10 at the first stage are connected to the solar battery cells 10 at a second stage by the connecting line 27a. Six solar battery cells 10 at the second stage are serially connected and the solar battery cells 10 at the second stage are connected to the solar battery cells 10 at a third stage by the connecting line 27b. Five solar battery cells 10 at the third stage are serially connected and the solar battery cells 10 at the third stage are connected to the solar battery cells 10 at a fourth stage by the connecting line 27c. Four solar battery cells 10 at the fourth stage are serially connected and the four solar battery cells 10 at the fourth stage are connected to the solar battery cells 10 at a fifth stage by a connecting line 27d, and three solar battery cells 10 at the fifth stage are serially connected. At both ends of the solar battery cells 10 connected serially in this manner, output lines 28a and 28b are connected. Although the thin plate 20 is omitted in Fig. 5, it is provided to be overlapped with the connecting lines 27a and 27c and the output line 28b provided on the edge side in a stepwise shape of the solar battery cell group.

Fig. 6 is an enlarged view of an obtuse-angled corner between the oblique side and the adjacent side for explaining a gap between a solar battery cell and an output line. A size of a gap between the thin plate 20 and the output line 28b and a size of a gap between the solar battery cell 10 and the output line 28b are rendered the same as the size of S6. That is, the output line 28b is arranged to overlap the end on a side of the solar battery cell group of the thin plate 20.

Fig. 7 is a cross-sectional view which is not part of the present invention for explaining hiding of the connecting lines and the output lines by the thin plate. In Fig. 7, similarly to Fig. 2, to facilitate understanding of various members in each of laminated layers, the thickness of each layer is shown larger and gaps are interposed between the respective layers. In Fig. 7, a connecting line/output line (which collectively represents the connecting lines 27a and 27c and the output line 28b) 27 (28) is arranged on a bottom-surface side of the thin plate 20, are thus it is hidden by the thin plate 20 and cannot be seen from above. Accordingly, the designing property is improved.

Fig. 8 is a cross-sectional view for explaining an arrangement of the connecting lines and the output lines according to the present invention. The conecting line/output 27 (28) shown in Fig. 8, which is arranged on a light-receiving surface side of the thin plate 20, is seen from the light-receiving surface side. By having such a structure, it becomes easier to check burr or flash that can be generated in the connecting line/output line 27 (28). With respect to burr or flash of the connecting line/output line 27 (28), because the thin plate 20 is made of an electric insulating material, even when the burr or flash is generated in the connecting line/output line 27 (28) the electric insulating performance can be improved.

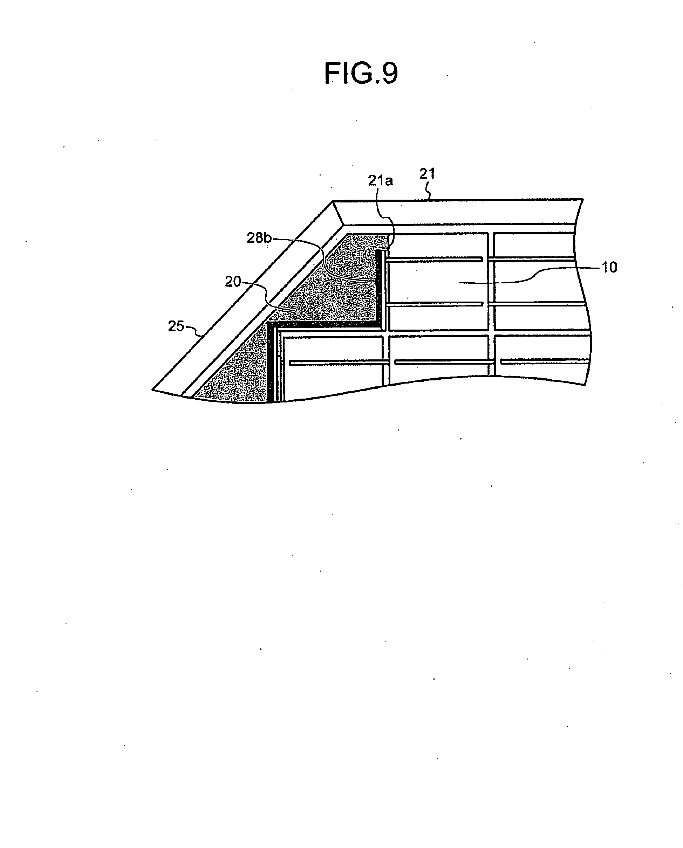

Fig. 9 is an enlarged view of an obtuse-angled corner between the oblique side and the adjacent side for explaining a positioning protrusion provided on the thin plate. In Fig. 9, at an outer periphery of both end portions of the thin plate 20, a positioning protrusion 21a that comes into contact with the solar battery cell 10 is provided. At an upper end portion in Fig. 9, the positioning protrusion 21a that comes into contact with the solar battery cell 10 at a fifth stage is provided. Although not shown in Fig. 9, at an end portion opposite to the positioning protrusion 21a of the thin plate 20, a positioning protrusion that comes into contact with the solar battery cell 10 at a first stage is provided. As described above, when the positioning protrusion 21a that comes into contact with the solar battery cell 10 is provided, positioning of the thin plate 20 can be easily performed, thereby improving the workability. The positioning protrusion 21a becomes effective when it is provided at the both end portions of the elongated thin plate 20 as is in the present embodiment.

As described above, the solar cell module 100 is configured by laminating a plurality of layers including a cell arrangement layer C, on which the plurality of solar battery cells 10 are arranged, and in the blank region D other than where the solar battery cells 10 of the cell arrangement layer C are arranged, the thin plate 20 having a color tone same as that of the solar battery cell 10 is arranged. The solar battery cells 10 and the thin plate 20 are arranged on the same cell arrangement layer C, and thus good designing is enabled without causing any sense of discomfort. Further, it suffices that the thin plate 20 is arranged on the cell arrangement layer C at a step same as a step in which the solar battery cells 10 is arranged on the cell arrangement layer C, and thus the arrangement of the thin plate 20 can be easily performed and no cost increase is incurred.

Any type of the solar cell module 100 can provide a predetermined effect as long as the following conditions are met: the entire shape is in a plate-like shape having an oblique side at least on one side thereof, the solar battery cell 10 is in a substantially square plane-surface shape, and the blank region D has at least one substantially triangular region formed between the oblique side and the solar battery cell 10. Moreover, when the blank region D forms a shape obtained by connecting a plurality of triangles so that respective tops are overlapped with one another and the thin plate 20 forms a shape same as that of the blank region D, better effects can be achieved.

The cell arrangement layer C is formed such that it is sandwiched by layers made of the transparent substrate 31 and the weather resistant film (bottom surface film) 35, the color on the light-receiving surface side in the weather resistant film 35 is bright (white), and the color tones of the solar battery cell 10 and the thin plate 20 are dark (black). Thus, a good appearance in terms of designing can be maintained, and the taken light is reflected onto a side of the solar battery cell 10, thereby improving the performance.

Furthermore, the solar cell module 100 has the frames 21 to 25 that cover the outer peripheral edge, the size of the gap between the thin plate 20 and the frames 21 to 25 is rendered substantially the same as that of the gap between the solar battery cell 10 and the frames 21 to 25, the size of the gap between the thin plate 20 and the solar battery cell 10 is rendered substantially the same as that of the gap between the solar battery cells 10, and the size of the gap between the thin plate 20 and the connecting lines 27a and 27c is rendered substantially the same as that of the gap between the solar battery cell 10 and the connecting lines 27a and 27c. Thus, better designing can be achieved.

### INDUSTRIAL APPLICABILITY

As described above, the solar cell module according to the present invention is a solar cell module installed particularly on a hip roof of a conventional house, and is suitable to a solar cell module having an oblique surface of a trapezoid, a triangle or the like.

## Claims

1. A solar cell module structured by laminating a
plurality of layers including a cell arrangement layer (C), on which a plurality of solar battery cells (10) are arranged,
wherein in a blank region (D) other than where the solar battery cells (10) of the cell arrangement layer (C) are arranged, a thin plate (20) having a color tone same as that of the solar battery cells (10) is arranged, **characterized in that** the cell arrangement layer (C) is formed by being sandwiched by layers made of a transparent substrate (31) and a bottom surface film (35), a color tone of the bottom surface film (35) being bright, and color tones of the solar battery cells (10) and the thin plate (20) being dark,
wherein the thin plate (20) is arranged such that the thin plate (20) is sandwiched by a sealing resin layer (32, 34) between layers made of the transparent substrate (31) and the bottom surface film (35), and surface processing being applied on a top surface of the thin plate (20) to improve a bonding force between the top surface and the sealing resin layer (32, 34), and
wherein in the sealing resin layer (32, 34) between the thin plate (20) and the transparent substrate (31), a wire extending to the solar battery cells (10) is provided.

2. The solar cell module according to claim 1, wherein an entire shape of the solar cell module is in a plate-like shape having an oblique side at least on one side thereof, the solar battery cells (10) are in a substantially square and plane-surface shape, and the blank region (D) is at least one substantially triangular region formed between the oblique side and the solar battery cells (10).

3. The solar cell module according to any one of claims 1 to 2, wherein the thin plate (20) is made of an electric insulating material.

4. The solar cell module according to any one of claims 1 to 2, wherein a thickness of the thin plate (20) is equal to or less than a thickness of the solar battery cells (10).

5. The solar cell module according to any one of claims 1 to 2, wherein at an outer periphery of the thin plate (20), a positioning protrusion (21a) that comes into contact with the solar battery cells (10) is provided.

## Patentansprüche

1. Solarzellenmodul, das durch Laminieren einer Vielzahl von Schichten strukturiert ist, die eine Zellenanordnungsschicht (C) enthalten, auf der eine Vielzahl von Solarbatteriezellen (10) angeordnet sind,
wobei in einem leeren Bereich (D) mit Ausnahme davon wo die Solarbatteriezellen (10) der Zellenanordnungsschicht (C) angeordnet sind, eine dünne Platte (20) angeordnet ist, die einen gleichen Farbton aufweist wie der der Solarbatteriezellen (10),
**gekennzeichnet dadurch, dass**
die Zellenanordnungsschicht (C) durch Dazwischenschichten zwischen aus einem durchsichtigen Substrat (31) gefertigten Schichten und einem unteren Oberflächen-Film (35) gebildet ist, wobei ein Farbton des unteren Oberflächen-Films (35) hell ist, und Farbtöne der Solarbatteriezellen (10) und der dünnen Platte (20) dunkel sind,
wobei die dünne Platte (20) derart angeordnet ist, dass die dünne Platte (20) mittels einer Versiegelungs-Harz-Schicht (32, 34) zwischen aus durchsichtigem Substrat (31) gefertigten Schichten und dem unteren Oberflächen-Film (35) dazwischen geschichtet ist, und Oberflächen-Verarbeitung auf eine obere Oberfläche der dünnen Platte (20) angewandt wird, um eine Bindungskraft zwischen der oberen Oberfläche und der Versiegelungs-Harz-Schicht (32, 34) zu verbessern, und
wobei in der Versiegelungs-Harz-Schicht (32, 34) zwischen der dünnen Platte (20) und dem durchsichtigen Substrat (31) ein Draht, der sich zu der Solarbatteriezelle (10) erstreckt, vorhanden ist.

2. Solarzellenmodul nach Anspruch 1, wobei eine ganze Form des Solarzellenmoduls in einer platten-ähnlichen Form ist, die eine schräge Seite an zumindest einer ihrer Seiten aufweist, die Solarbatteriezellen (10) in einer im Wesentlichen quadratischen und oberflächenplanen Form sind, und der leere Bereich (D) zumindest ein im Wesentlichen dreieckiger Bereich ist, der zwischen der schrägen Seite und den Solarbatteriezellen (10) gebildet ist.

3. Solarzellenmodul nach einem der Ansprüche 1 bis 2, wobei die dünne Platte (20) aus einem elektrisch isolierenden Material gefertigt ist.

4. Solarzellenmodul nach einem der Ansprüche 1 bis 2, wobei eine Dicke der dünnen Platte (20) gleich oder geringer als eine Dicke der Solarbatteriezelle (10) ist.

5. Solarzellenmodul nach einem der Ansprüche 1 bis 2, wobei in einem äußeren Umkreis der dünnen Platte (20), ein Positionierungs-Vorsprung (21a) vorhanden ist, der mit den Solarbatteriezellen (10) in Kontakt kommt.

## Revendications

1. Module de cellule solaire structuré en stratifiant une pluralité de couches qui comprend une couche d'agencement de cellule (C), sur laquelle sont agencées une pluralité de cellules de batterie solaire (10);
dans lequel est agencée, dans une région vide (D) autre que là où sont agencées les cellules de batterie solaire (10) de la couche d'agencement de cellule (C), une plaque mince (20) qui présente un ton de couleur identique à celui des cellules de batterie solaire (10), **caractérisé en ce que** la couche d'agencement de cellule (C) est formée en étant prise en sandwich par des couches réalisées dans un substrat transparent (31) et un film de surface inférieur (35), le ton de couleur du film de surface inférieur (35) étant clair, et les tons de couleur des cellules de batterie solaire (10) et de la plaque mince (20) étant foncés, dans lequel la plaque mince (20) est agencée de telle sorte que la plaque mince (20) est prise en sandwich par une couche de résine d'étanchéité (32, 34) entre des couches réalisées dans le substrat transparent (31) et le film de surface inférieur (35), et un traitement de surface étant appliqué sur une surface supérieure de la plaque mince (20) de façon à améliorer la force de liaison entre la surface supérieure et la couche de résine d'étanchéité (32, 34) ; et
dans lequel est prévu, dans la couche de résine d'étanchéité (32, 34) entre la plaque mince (20) et le substrat transparent (31), un fil qui s'étend vers les cellules de batterie solaire (10).

2. Module de cellule solaire selon la revendication 1, dans lequel la totalité de la forme du module de cellule solaire présente une forme similaire à une plaque qui présente un côté oblique au moins sur un côté de celle-ci, les cellules de batterie solaire (10) présentant une forme sensiblement carrée et une surface plane, et la région vide (D) présentant au moins une région sensiblement triangulaire formée entre le côté oblique et les cellules de batterie solaire (10).

3. Module de cellule solaire selon la revendication 1 ou la revendication 2, dans lequel la plaque mince (20) est réalisée dans un matériau isolant de manière électrique.

4. Module de cellule solaire selon la revendication 1 ou la revendication 2, dans lequel l'épaisseur de la plaque mince (20) est égale ou inférieure à l'épaisseur des cellules de batterie solaire (10).

5. Module de cellule solaire selon la revendication 1 ou la revendication 2, dans lequel est fournie, au niveau de la périphérie extérieure de la plaque mince (20), une saillie de positionnement (21 a) qui entre en contact avec les cellules de batterie solaire (10).
